# EUROPEAN PATENT APPLICATION

(11) **EP 2 696 373 A1**
(43) Date of publication of application: **12.02.2014**
(21) Application number: 11863183.7
(22) Date of filing: 30.11.2011
(51) Int. Cl.: H01L 31/042, H01L 31/0224

(54) **DYE-SENSITIZED SOLAR CELL COMPRISING ION LAYER AND METHOD FOR MANUFACTURING SAME**

(30) Priority: 04.04.2011 KR 20110030839
(71) Applicant: Postech Academy-Industry Foundation, Pohang-si, Gyeongsangbuk-do 790-784 (KR)
(72) Inventor: PARK, Taiho, Pohang-si 790-751 (KR); KWON, Young-Soo, Pohang-si 790-784 (KR); PARK, Sung Hae, Busan 607-060 (KR); LIM, Jong Chul, Anseong-si 456-747 (KR)
(74) Representative: Ahner, Philippe
(86) International application number: PCT/KR2011/009228
(87) International publication number: WO 2012/138037

(57) **Abstract**

The present invention relates to a dye-sensitized solar cell and to a method for manufacturing same, and more specifically, provides a novel dye-sensitized solar cell for preventing photoelectron recombination due to a triiodide, and to a method for manufacturing same. The dye-sensitized solar cell, according to the present invention, comprises a metal oxide resulting from coadsorbing, on a surface of the dye-sensitized solar cell, a reactive compound which can react with iodine with a dye. The dye-sensitized solar cell is highly efficient by being able to prevent the photoelectron recombination due to the triiodide while using a small amount of the dye.

## Description

### Technical Field

The present invention relates to a dye-sensitized solar cell and a method of manufacturing the same, and, more particularly, to a novel dye-sensitized solar cell, which may prevent photoelectron recombination due to a triiodide and desorption of a dye, and to a method of manufacturing the same.

### Background Art

Solar cells are devices which directly produce electricity using a light-absorbing material which generates electrons and holes upon irradiation of light, and are based on a photovoltaic effect. The photovoltaic effect in which a chemical reaction induced by light generates current was first discovered by Becquerel, a French physicist, in 1839, and a phenomenon similar thereto was then found in a solid such as selenium.

In 1991, the Switzerland Grätzel research team published a method of manufacturing a solar cell having a photoelectric conversion efficiency of 10% by chemically adsorbing a Ru(porphyrin) dye on anatase TiO₂ having a nano crystal structure and by using iodine and an iodine salt dissolved in a solution electrolyte. The photoelectric conversion efficiency of the dye-sensitized solar cell (hereinafter referred to as "DSSC") is known to be higher than that of typical amorphous silicon-based solar cells, and DSSC is currently regarded as the most advanced technology able to substitute for silicon diodes.

The DSSC includes a semiconductor electrode made of porous titanium dioxide (TiO₂) nanoparticles adsorbed with dye molecules, a counter electrode coated with platinum or carbon, and an electrolyte charged between the semiconductor electrode and the counter electrode. Briefly, the DSSC is a solar cell comprising a transparent electrode and a metal electrode, inorganic oxide layer such as titanium oxide which is adsorbed with a dye, and an electrolyte filling between the electrodes, and using a photoelectrochemical reaction.

Typically, the DSSC includes two electrodes (a photoelectrode and a counter electrode), an inorganic oxide, a dye and an electrolyte. The DSSC is eco-friendly because it uses an environmentally harmless material, and it has high energy conversion efficiency corresponding to that of amorphous silicon-based solar cells among conventional inorganic solar cells, and the manufacturing cost thereof is merely about 20% of that of silicon solar cells, and thus the DSSC has been reported to have very high commercialization potential (US Patent Nos. 4,927,721 and 5,350,644).

In the operating principle of the DSSC, when light is radiated onto a dye-adsorbed titanium oxide layer, the dye absorbs photons (electron-hole pairs) to form excitons, and the formed excitons are converted from a ground state into an excited state. Thereby, the electron-hole pairs are separated, so that the electrons are implanted into the titanium oxide layer, and the holes are transported into the electrolyte layer. Further, when an external circuit is provided, the electrons are transported to a cathode from an anode via the titanium oxide layer through conductive wires, thus generating current. The electrons transported to the cathode are reduced by the electrolyte, so that the electrons in an excited state are continuously transported, thus generating current.

In order to increase the photoelectric conversion efficiency of the DSSC, the absorption of solar light should be increased first so that the production of electrons increases. Because the absorption of solar light is proportional to the amount of adsorbed dye, the adsorption of the dye should be increased in order to raise the absorption of solar light, and oxide semiconductor particles are manufactured on a nanometer scale in order to increase the adsorption of the dye per unit area, thereby enlarging the surface area of the oxide semiconductor. However, limitations are imposed on increasing the photoelectric conversion efficiency of solar cells using such methods.

The electrons transported to the semiconductor oxide by the dye may be recombined with oxidized chemical species present in solar cells while passing through the semiconductor oxide layer, undesirably losing photoelectrons. Particularly, in the DSSC using iodine and iodine ions as oxidation-reduction species, recombination is known to be mainly caused by a reaction between photoelectrons present on the surface of metal oxide and triiodide ions or oxidized dye.

Thus, methods of preventing the photoelectrons from approaching the oxidation species or preventing the oxidation species from approaching the photoelectrons have been developed. First, there is provided a method of introducing ethyleneglycol to the hole transport material of a p-type semiconductor to chelate lithium ions, thus screening electrons which approach from TiO₂ to thereby delay the recombination (Taiho Park, et al., Chem. Comm. 2003, 11, 2878; Saif A. Haque, et al., Adv. Func. Mater. 2004, 14, 435). Second, there is provided a method of adding a base having high toxicity, for example, a tertiary aromatic amine to an electrolyte to improve open-circuit voltage (M. K. Nazeeruddin, et al., J. Am. Chem. Soc., 1993, 115, 6382).

Also, there have been exemplified the formation of an insulating layer on the exposed surface of the semiconductor oxide layer of a semiconductor electrode and the exposed surface of a conductive substrate (Korean Unexamined Patent Publication No. 2008-0029597) and the adsorption of a dye on the surface of a semiconductor electrode coated with aluminum oxide or another metal oxide (Emilio Palomares, et al., J. Am. Chem. Soc. 2003, 125, 475-482; Shlomit Chappel, et al., Langmuir 2002, 18, 3336-3342).

In addition, a method of preventing leakage of an electrolyte by mixing a polymer thin film with the electrolyte has been disclosed (Korean Unexamined Patent Publication No. 2009-0012911).

However, in the aforementioned methods, it is difficult to control the recombination of photoelectrons occurring on the surface of the metal oxide, and thus there is a continuous need for methods that are able to solve such problems.

Further, the dye is adsorbed by forming a carboxylate on the surface of TiO₂, and the chemically bound dye is desorbed by water molecules present in the electrolyte or nucleophilic molecules produced via thermal decomposition of the electrolyte at high temperature, and is thus dissolved in the electrolyte, and the dissolved dye cannot produce photoelectrons, undesirably lowering the efficiency of the DSSC, which is known to be mainly caused by the desorption of the dye. In order to ensure long-term stability of the DSSC, methods of removing such water molecules or nucleophilic molecules from the inside of the DSSC are required.

### Disclosure

### Technical Problem

An object of the present invention is to provide a novel method which prevents a triiodide ion from approaching the surface of a metal oxide, thereby increasing optical efficiency of a dye-sensitized solar cell and ensuring long-term stability.

Another object of the present invention is to provide a novel method which prevents a triiodide ion from approaching the surface of a metal oxide and in which a dye is dispersed and adsorbed, thus increasing optical efficiency of a dye-sensitized solar cell and ensuring ensure long-term stability.

Yet another object of the present invention is to provide a novel dye-sensitized solar cell and a method of manufacturing the same, wherein photoelectron recombination due to a triiodide ion is prevented and the amount of the dye used is decreased.

### Technical Solution

According to the present invention, a dye-sensitized solar cell is configured such that an ion layer, preferably a halogen ion layer, is formed on a dye-adsorbed metal oxide, in order to prevent electrons from disappearing due to recombination with the oxide.

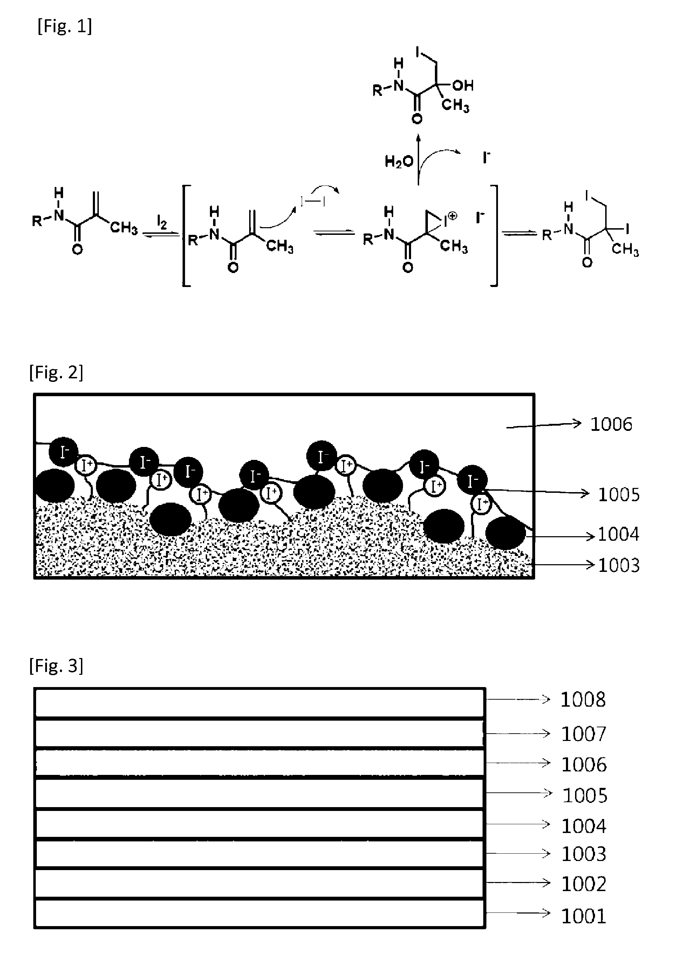

In the present invention, the halogen ion layer is an iodine ion layer or a bromine ion layer. The halogen ion layer may be formed by reacting a functional group formed on the surface of the metal oxide, for example, an unsaturated group such as a double bond, with a halogen (FIG. 1).

In an embodiment of the present invention, the functional group such as a double bond formed on the surface of the metal oxide is preferably formed by adsorbing a reactive compound having a functional group at the terminal thereof on the surface of the metal oxide.

The reactive compound is preferably adsorbed on the surface of the metal oxide, along with the dye. In this case, the reactive compound acts as a co-adsorbent, and is thus competitively adsorbed along with the dye on the surface of the metal oxide in the adsorption process, thus decreasing the amount of adsorbed dye and preventing aggregation of the dye. Further, as illustrated in FIG. 2, the adsorbed reactive compound reacts with a halogen molecule such as iodine or bromine, so that a halogen ion layer such as an iodine ion layer having high electron density is formed on the surface of the metal oxide, thereby preventing approach of a triiodide ion present in an electrolyte and thus prohibiting the recombination of photoelectrons, as illustrated in FIG. 3. Also, the energy level of the surface of the metal oxide is changed, thus improving open-circuit voltage and short-circuit current. Also, the reactive compound reacts with water molecules or nucleophilic molecules present in the electrolyte, thus preventing desorption of the dye, consequently enabling the cell to be driven for a long period of time.

In the present invention, the reactive compound has one or more double bonds able to react with a halogen to form a halogen ion layer at the terminal thereof or in the chain thereof, and also contains a carboxyl group, acyl halide, alkoxy silyl, halide silyl, or phosphorus which enables the adsorption on a semiconductor metal oxide electrode. This compound may be used alone or in a mixture of two or more.

In a preferred embodiment of the present invention, the reactive co-adsorbent may be represented by the following general formulas (1) to (4).

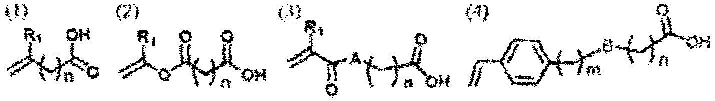

In the above formulas, R₁ is hydrogen, or a C1 ∼ C10 alkyl group, A is a carbon atom, a nitrogen atom, an oxygen atom, a silicon atom, a phosphorus atom, etc., n is a natural number of 1 ∼ 40, m is 0 or a natural number of 1 ∼ 10, and B is a connector containing a carbon atom, a nitrogen atom, an oxygen atom, a silicon atom, a phosphorus atom or mixtures thereof. Examples of general formula (1) include but-3-enoic acid, pent-4-enoic acid, hex-4-enoic acid, hep-4-enoic acid, non-9-enoic acid, etc. Examples of general formula (2) include malonic acid monovinylester, succinic acid monovinylester, heptanedioic acid monovinylester, etc. Examples of general formula (3) include 4-oxo-hex-5-enoic acid, acrylic acid carboxymethyl ester, methacryloyl-4-aminobutyric acid, 6-acryloylamino-hexanoic acid, 9-acryloylamino-nonanoic acid, 6-(2-methyl-acryloylamino)-hexanoic acid, 9-(2-methyl-acryloylamino)-nonanoic acid, 14-acryloyloxy-tetradecanoic acid, 14-(2-methyl-acryloyloxy-tetradecanoic acid), etc. Examples of general formula (4) include 4-(4-vinyl-phenyl)butyric acid, 4-(4-vinyl-phenoxy)-propionic acid, 6-(4-vinyl-phenyl)hexylic acid, 6-(4-vinyl-phenoxy)-hexanoic acid, etc.

An aspect of the present invention provides a metal oxide semiconductor electrode for a dye-sensitized solar cell, which includes a halogen ion layer, for example, an iodine ion layer or a bromine ion layer, formed by adsorbing one or more dye molecules and a reactive compound together on a porous film having metal oxide semiconductor particles.

The present invention also provides a dye-sensitized solar cell including the metal oxide electrode. The dye-sensitized solar cell according to the present invention includes a conductive first electrode, a metal oxide semiconductor layer formed on the first electrode, a semiconductor electrode adsorbed with one or more dye molecules formed on the metal oxide semiconductor layer, and a counter electrode having a metal layer formed on a second substrate. The present invention provides a method of manufacturing the dye-sensitized solar cell, comprising injecting an electrolyte including an oxidation-reduction derivative between a semiconductor electrode and a counter electrode, or applying a polymer gel electrolyte composition including an oxidation-reduction derivative on a semiconductor electrode, thus forming a polymer gel electrolyte, on which a second electrode is then positioned and bound.

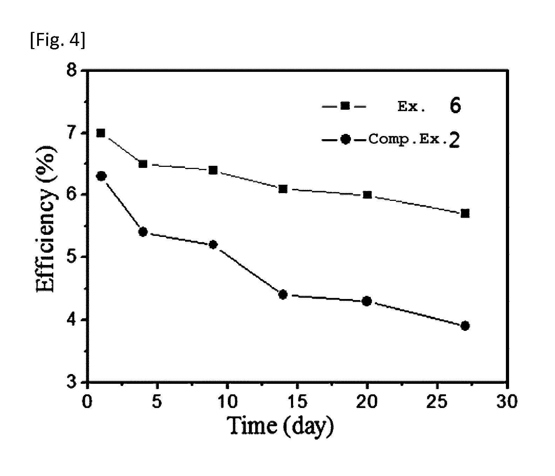

FIG. 4 is a cross-sectional view schematically illustrating the dye-sensitized solar cell manufactured using a metal oxide semiconductor electrode adsorbed with dye molecules according to a preferred embodiment of the present invention. As illustrated in this drawing, the dye-sensitized solar cell manufactured according to the preferred embodiment of the present invention is provided in the form of a multilayer thin film configured such that a first electrode 1002 and a second electrode 1007 are disposed to face each other between two transparent substrates, that is, a first substrate 1001 and a second substrate 1008, and an inorganic oxide layer 1003, a dye/reactive compound layer 1004, an iodine ion layer 1005 resulting from reaction of the reactive compound and an iodine molecule, and an electrolyte layer 1006 are disposed between the first electrode 1002 and the second electrode 1007.

The first substrate 1001 may be made of a transparent material such as glass or plastic, including PET (polyethylene terephthalate), PEN (polyethylene naphthalate), PP (polypropylene), PI (polyamide), TAC (tri acetyl cellulose), etc., and is preferably made of glass.

The first electrode 1002 is an electrode formed on one surface of the first substrate 1001 using a transparent material. The first electrode 1002 functions as an anode, and the first electrode 1002 may be formed of any material having transparency and conductivity as a material having a work function lower than the second electrode 1008. In the present invention, the first electrode 1002 may be provided in the form of a coating film or applied on the surface of the first substrate 1001 using sputtering or spin coating.

In regard to the present invention, the material for the first electrode 1002 may be arbitrarily selected from among ITO (indium-tin oxide), FTO (fluorine doped tin oxide), ZnO-(Ga₂O₃ or Al₂O₃), SnO₂-Sb₂O₃, etc. Preferably useful is ITO or FTO.

The inorganic oxide layer 1003 is preferably made of a transition metal oxide in a nanoparticle form, for example, a transition metal oxide, such as titanium oxide, scandium oxide, vanadium oxide, zinc oxide, gallium oxide, yttrium oxide, zirconium oxide, niobium oxide, molybdenum oxide, indium oxide, tin oxide, lanthanide oxide, tungsten oxide, or iridium oxide, an alkaline earth metal oxide such as magnesium oxide or strontium oxide, aluminum oxide, etc. In regard to the present invention, a material particularly useful as the inorganic oxide is titanium oxide in a nanoparticle form. The inorganic oxide layer 1003 according to the present invention is applied on the first electrode 1002 by coating one surface of the first electrode 1002 therewith and then performing heat treatment. Typically, a paste including an inorganic oxide may be applied to a thickness of about 5 ∼ 30 µm, preferably 10 ∼ 15 µm on the surface of the first electrode 1002 using a doctor blade process or a screen printing process, or a spin coating process, a spraying process, a wet coating process, etc., may be carried out.

On the other hand, the dye transfers electrons to the inorganic oxide and is then oxidized, but receives electrons transported to the electrolyte layer 1006 and thus is reduced to an original state. Accordingly, the electrolyte layer 1006 receives electrons from the second electrode 1007 to transport them to the dye.

According to the present invention, a photosensitive dye chemically adsorbed on the inorganic oxide layer 1003 may include a dye such as a ruthenium complex as a material able to absorb light in the UV light and visible light ranges. For example, the photosensitive dye may include a ruthenium complex, such as Ruthenium 535 dye, Ruthenium 535 bis-TBA dye, Ruthenium 620-1H3TBA dye, etc. Preferably useful is a Ruthenium 535 bis-TBA dye. The photosensitive dye which may be chemically adsorbed on the inorganic oxide layer 1003 may include any dye having a charge separation function, such as a xanthene-based dye, a cyanine-based dye, a porphyrin-based dye, an anthraquinone-based dye, and an organic dye, in addition to the ruthenium-based dye.

The dye may be adsorbed on the inorganic oxide layer 1003 using a typical process. Preferably, the dye may be adsorbed by dissolving the dye in a solvent such as alcohol, nitrile, halogenated hydrocarbon, ether, amide, ester, ketone, N-methylpyrrolidone, etc., or preferably dissolving the dye in a co-solvent of acetonitrile and t-butanol, and then immersing the photoelectrode coated with the inorganic oxide layer 1003 in the dye solution.

The electrolyte used in the electrolyte layer 1006 may include a combination of I₂ and a metal iodide or an organic iodide (metal iodide or organic iodide/I₂) or a combination of Br₂ and a metal bromide or an organic bromide (metal bromide or organic bromide/Br₂) as a redox couple.

In the electrolyte used in the present invention, the metal cation of the metal iodide or the metal bromide may include Li, Na, K, Mg, Ca, Cs, etc., and the cation of the organic iodide or the organic bromide may include an ammonium compound such as imidazolium, tetra-alkyl ammonium, pyridinium, triazolium, etc., but the present invention is not limited thereto, and these compounds may be used in mixtures of two or more. Preferably useful as the redox couple is a combination of Lil or imidazolium iodide and iodine.

Examples of the organic halide useful as the ionic liquid in the electrolyte according to the present invention may include n-methylimidazolium iodide, n-ethylimidazolium iodide, 1-benzyl-2-methylimidazolium iodide, 1-ethyl-3-methylimidazolium iodide, 1-butyl-3-methylimidazolium iodide, etc. Preferably useful is 1-ethyl-3-methylimidazolium iodide, and these may be used in a combination with iodine (I₂). In the case where such an ionic liquid, that is, a dissolved salt, is used, a solid electrolyte in which no solvent is used in the electrolyte composition may be provided.

The second electrode 1007 is an electrode applied on the surface of the second substrate 1008, and functions as a cathode. The second electrode 1007 may be applied on the surface of the second substrate 1008 by sputtering or spin coating. The material for the second electrode 1007 has a work function higher than the material for the first electrode 1002, and examples thereof may include platinum (Pt), gold (Au), silver (Ag), carbon (C), etc. Preferably useful is platinum.

The second substrate 1008 may be made of a transparent material as in the case of the first substrate 1001, including glass, or plastic, such as PET, PEN, PP, PI, TAC, etc., and is preferably made of glass.

The process of manufacturing the dye-sensitized solar cell according to the embodiment of the present invention is described below.

Specifically, an inorganic oxide such as titanium oxide in a colloidal state is preferably applied or cast to a thickness of about 5 ∼ 30 µm on a first substrate coated with a first electrode material, and sintered at about 450 ∼ 550°C, thus forming a photoelectrode comprising the organic material-free first substrate, the first electrode and the inorganic oxide which are sequentially applied/layered. Subsequently, in order to adsorb a dye on the inorganic oxide layer, a dye, for example, a ruthenium-based N719 dye and a reactive compound are added to a previously prepared ethanol solution, thus preparing a dye solution, after which a transparent substrate (e.g. a glass substrate coated with FTO, etc., a photoelectrode) coated with the inorganic oxide layer is immersed in the dye solution, so that the dye and the reactive co-adsorbent are adsorbed. A platinum precursor material on the glass substrate is sintered, thus manufacturing a platinum electrode, which is then bound to a semiconductor electrode adsorbed with the dye and the reactive co-adsorbent, followed by injecting an electrolyte, thereby manufacturing a dye-sensitized solar cell according to the present invention.

### Advantageous Effects

According to a semiconductor electrode of the present invention, a reactive organic compound is co-adsorbed with dye and reacts with iodine which is dissolved in an electrolyte. The oxidized dye interposed between the counter electrode and semiconductor electrode is regenerated by transporting holes to a counter electrode.

The reactive compound can react with iodine, thus forming an iodine ion layer, thereby preventing aggregation of dye molecules. Accordingly, transfer of electrons between the dye molecules can be minimized, and simultaneously, photoelectrons resulting from an excited state of the dye and present in a flat band of a TiO₂ metal oxide can be minimized in terms of recombination with the oxidized dye, the oxidized chemical species in the electrolyte or the holes of the oxidized hole transport material, and the energy level of the flat band of the TiO₂ metal oxide is shifted to the vacuum energy level, thus improving open-circuit voltage. Consequently, the use of expensive dye can be drastically decreased, and photoelectron production efficiency of individual dye molecules can be maximized, thus lowering the production cost, and improving both open-circuit voltage and short-circuit current, resulting in a solar cell having photoelectrochemical properties able to improve energy conversion efficiency.

### Description of Drawings

FIG. 1 is a schematic view illustrating an organic chemical reaction between a dye and a reactive material according to the present invention;
FIG. 2 is a cross-sectional view illustrating the configuration of a dye-sensitized solar cell according to the present invention;
FIG. 3 is a schematic view illustrating the formation of a titanium oxide layer adsorbed with a dye and a reactive material, via reaction with iodine, according to the present invention; and
FIG. 4 is a graph illustrating a durability test for thermal (80°C) stability of the cells of Example 1 and Comparative Example 1.

### Mode for Invention

### Example 1

A composition for forming a TiO₂ (solaronix) porous film was applied using a doctor blade process on a transparent glass substrate having a substrate resistance of 15 Ω/□ and coated with fluorine-doped ITO. Drying and then heat treatment at 500°C for 30 min were carried out, thus forming a porous film having TiO₂. The thickness of the formed porous film was about 6 µm. Subsequently, a first electrode having the porous film was immersed for 18 hr in a solution comprising acetonitrile and tert-butanol (1:1 volume ratio) solvents and 0.30 mM ruthenium(4,4-dicarboxy-2,2'-bipyridine)₂(NCS) as a dye and 0.30 mM methacryloyl-4-aminobutyric acid as a reactive compound, so that the dye was adsorbed on the porous film.

A platinum paste (solaronix) was applied using a doctor blade process on a transparent glass substrate having a substrate resistance of 15 Ω/□ and coated with fluorine-doped ITO. Drying and then heat treatment at 450°C for 30 min were carried out, thus manufacturing a catalyst electrode to form a second electrode. A bore was formed in the second electrode using a 0.75 mm drill.

0.6M 1-butyl-3-methylimidazolium iodide, 0.03M iodine, 0.10M guanidinium thiocyanate, and 0.5M 4-tert-butylpyridine were dissolved in acetonitrile and valeronitrile (85:15 volume ratio) solvents, thus preparing an electrolyte, which was then injected via the bore, after which the bore was sealed with an adhesive, thereby manufacturing a dye-sensitized solar cell.

### Example 2

A dye-sensitized solar cell was manufactured in the same manner as in Example 1, with the exception that the electrolyte was prepared by dissolving 0.8M 1-butyl-3-methylimidazolium iodide, 0.03M iodine, and 0.2M 4-tert-butylpyridine in a methoxypropionitrile solvent.

### Example 3

A dye-sensitized solar cell was manufactured in the same manner as in Example 1, with the exception that methacryloyl-4-aminolauric acid was used as the reactive compound, instead of methacryloyl-4-aminobutyric acid.

### Example 4

A dye-sensitized solar cell was manufactured in the same manner as in Example 1, with the exception that acrylic acid carboxymethyl ester was used as the reactive compound, instead of methacryloyl-4-aminobutyric acid.

### Example 5

A dye-sensitized solar cell was manufactured in the same manner as in Example 1, with the exception that acrylic acid carboxymethyl ester was used as the reactive compound, instead of methacryloyl-4-aminobutyric acid.

### Comparative Example 1

A composition for forming a TiO₂ (solaronix) porous film was applied using a doctor blade process on a transparent glass substrate having a substrate resistance of 15 Ω/□ and coated with fluorine-doped ITO. Drying and then heat treatment at 500°C for 30 min were carried out, thus forming a porous film having TiO₂. The thickness of the formed porous film was about 6 µm. Subsequently, a first electrode having the porous film was immersed for 18 hr in a solution comprising acetonitrile and tert-butanol (1:1 volume ratio) solvents and 0.30 mM ruthenium(4,4-dicarboxy-2,2'-bipyridine)₂(NCS) as a dye, so that the dye was adsorbed on the porous film.

A platinum paste (solaronix) was applied using a doctor blade process on a transparent glass substrate having a substrate resistance of 15 Ω/□ and coated with fluorine-doped ITO. Drying and then heat treatment at 450°C for 30 min were carried out, thus manufacturing a catalyst electrode to form a second electrode. A bore was formed in the second electrode using a 0.75 mm drill.

0.6M 1-butyl-3-methylimidazolium iodide, 0.03M iodine, 0.10M guanidinium thiocyanate, and 0.5M 4-tert-butylpyridine were dissolved in acetonitrile and valeronitrile (85:15 volume ratio) solvents, thus preparing an electrolyte, which was then injected via the bore, after which the bore was sealed with an adhesive, thereby manufacturing a dye-sensitized solar cell.

### Example 6

The dye-sensitized solar cell of Example 1 was stored at 80°C, and the efficiency of the solar cell for 28 days was measured.

### Comparative Example 2

The dye-sensitized solar cell of Comparative Example 1 was stored at 80°C, and the efficiency of the solar cell for 26 days was measured.

| | Open-circuit voltage (V) | Short-circuit current (mA/cm²) | Filling factor (%) | Efficiency (%) |
|---|---|---|---|---|
| Ex. 1 | 0.726 | 16.8 | 60 | 6.9 |
| Ex. 2 | 0.726 | 16.7 | 57.8 | 7.0 |
| Ex. 3 | 0.714 | 16.2 | 59.9 | 6.9 |
| Ex. 4 | 0.732 | 16.5 | 60 | 7.2 |
| Ex. 5 | 0.723 | 16.2 | 58.5 | 7.3 |
| Comp. Ex. 1 | 0.701 | 15.1 | 59.1 | 6.3 |

In the present invention, the method of manufacturing a metal oxide semiconductor electrode in which a reactive organic material serving as a co-adsorbent and a dye are adsorbed together on a metal oxide is provided. The reactive compound used in the present invention is remarkably cheaper than the dye, but acts as the co-adsorbent, and is thus competitively adsorbed along with the dye on the surface of the metal oxide in the adsorption process, thus decreasing the amount of adsorbed dye and preventing the aggregation of the dye. The reactive compound reacts with iodine thus forming an iodine ion layer having high electron density on the surface of the metal oxide, so that approach of the triiodide ion is prevented, and recombination of photoelectrons is thereby prohibited, thus improving short-circuit current and changing the energy level of the metal oxide to thus simultaneously improve open-circuit voltage. Therefore, the method according to the present invention has very high industrial applicability because it is a low cost and high efficiency technique for development of the dye-sensitized solar cell that is able to achieve both high efficiency and low cost.

Although the preferred embodiments of the present invention have been disclosed for illustrative purposes, those skilled in the art will appreciate that various modifications, additions and substitutions are possible, without departing from the scope and spirit of the invention as disclosed in the accompanying claims.

## Claims

1. A dye-sensitized solar cell, comprising a semiconductor electrode, a counter electrode and an electrolyte, wherein the semiconductor electrode is configured such that a dye is adsorbed on a porous thin film including an oxide semiconductor and an ion layer is formed thereon.

2. The dye-sensitized solar cell of claim 1, wherein the ion layer is a halogen ion layer.

3. The dye-sensitized solar cell of claim 2, wherein the ion layer is an iodine ion layer, a bromine ion layer, or a mixed ion layer thereof.

4. The dye-sensitized solar cell of claim 2 or 3, wherein the ion layer is formed by coupling a reactive compound adsorbed on a surface of a metal oxide with a halogen of the electrolyte.

5. The dye-sensitized solar cell of claim 4, wherein the reactive compound is co-adsorbed along with the dye.

6. The dye-sensitized solar cell of claim 3 or 4, wherein the reactive compound is one or more selected from among the following formulas (1) to (4): 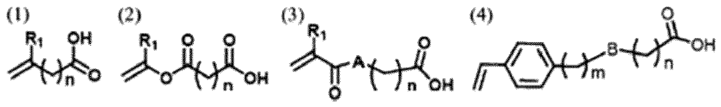 wherein R₁ is hydrogen, or a C1 ∼ C10 alkyl group, A is a carbon atom, a nitrogen atom, an oxygen atom, a silicon atom, or a phosphorus atom, n is a natural number of 1 ∼ 40, m is 0 or a natural number of 1 ∼ 10, and B is a connector comprising one or more selected from among a carbon atom, a nitrogen atom, an oxygen atom, a silicon atom, and a phosphorus atom.

7. The dye-sensitized solar cell of claim 6, wherein the reactive compound is one or more selected from among but-3-enoic acid, pent-4-enoic acid, hex-4-enoic acid, hep-4-enoic acid, non-9-enoic acid, malonic acid monovinylester, succinic acid monovinylester, heptanedioic acid monovinylester, 4-oxo-hex-5-enoic acid, acrylic acid carboxymethyl ester, methacryloyl-4-aminobutyric acid, 6-acryloylamino-hexanoic acid, 9-acryloylamino-nonanoic acid, 6-(2-methyl-acryloylamino)-hexanoic acid, 9-(2-methyl-acryloylamino)-nonanoic acid, 14-acryloyloxy-tetradecanoic acid, 14-(2-methyl-acryloyloxy-tetradecanoic acid), 4-(4-vinyl-phenyl)butyric acid, 4-(4-vinyl-phenoxy)-propionic acid, 6-(4-vinyl-phenyl)hexylic acid, and 6-(4-vinyl-phenoxy)-hexanoic acid.

8. A dye-sensitized solar cell, comprising:
a first electrode;
a counter electrode of the first electrode; and
an electrolyte including a redox couple,
wherein the first electrode includes a porous thin film including oxide semiconductor particles, and a dye and a compound which is coupled with a halogen molecule of the electrolyte to form an ion layer are co-adsorbed on a surface of the porous thin film.

9. The dye-sensitized solar cell of claim 8, wherein the ion layer is an iodine ion layer.

10. The dye-sensitized solar cell of claim 8, wherein the iodine ion layer prevents contact between a triiodide ion and an oxide semiconductor.

11. The dye-sensitized solar cell of claim 8, wherein the compound which forms the ion layer has an adsorption group which is adsorbed on the oxide semiconductor at one side thereof and a halogen coupling group at the other side thereof.

12. The dye-sensitized solar cell of claim 10, wherein the adsorption group includes one or more selected from among a carboxyl group, acyl halide, alkoxy silyl, halide silyl, and phosphorus, and the halogen coupling group is a double bond.

13. An oxide semiconductor electrode, which is configured such that a compound which is coupled with a halogen of an electrolyte to form a halogen ion layer is adsorbed on a surface thereof.

14. The oxide semiconductor electrode of claim 13, wherein the compound is co-adsorbed along with a dye.

15. The oxide semiconductor electrode of claim 13, wherein the compound has an adsorption group comprising one or more selected from among a carboxyl group, acryl halide, alkoxy silyl, halide silyl, and phosphorus at one side thereof, and a double bond which is coupled with the halogen at the other side thereof.

16. The oxide semiconductor electrode of claim 13, wherein the oxide semiconductor electrode comprises TiO₂ particles.

17. A method of manufacturing a dye-sensitized solar cell, comprising:
co-adsorbing a dye for absorbing solar light and a reactive compound on metal oxide semiconductor particles, thus forming a first electrode;
forming a counter electrode; and
injecting an electrolyte including a halogen/halide as a redox couple between the first electrode and the counter electrode,
wherein the reactive compound reacts with the halogen to form a halogen ion layer.

18. The method of claim 17, wherein the halogen ion layer is an iodine ion layer.

19. The method of claim 17 or 18, wherein the ion layer is formed by reacting the halogen contained in the electrolyte with a double bond of the reactive compound.

20. A method, comprising forming an ion layer on a surface of a metal oxide semiconductor layer so that contact between a metal oxide semiconductor and an oxide is prevented, in order to increase efficiency of a solar cell.
